# EUROPEAN PATENT SPECIFICATION

(11) **EP 2 705 657 B1**
(45) Date of publication and mention of the grant of the patent: **15.08.2018**
(21) Application number: 12727697.0
(22) Date of filing: 04.05.2012
(51) Int. Cl.: H04N 5/33, H04N 5/335, H04N 5/225, H01L 27/146

(54) **USING A MULTI-CHIP SYSTEM IN A PACKAGE (MCSiP) IN IMAGING APPLICATIONS TO YIELD A LOW COST, SMALL SIZE CAMERA ON A CHIP**
VERWENDUNG EINES MULTICHIP-SYSTEMS IN EINEM PAKET (MCSIP) BEI BILDGEBUNGSANWENDUNGEN ZUR GEWINNUNG EINER KOSTENGÜNSTIGEN KLEINEN KAMERA AUF EINEM CHIP
UTILISATION D'UN SYSTÈME MULTIPUCE DANS UN BOÎTIER (MCSIP) DANS DES APPLICATIONS D'IMAGERIE POUR PRODUIRE UNE CAMÉRA DE PETITE TAILLE À BAS COÛT SUR UNE PUCE

(30) Priority: 06.05.2011 US 201161483465 P; 20.06.2011 US 201113164432
(43) Date of publication of application: 12.03.2014
(73) Proprietor: Raytheon Company, Waltham, MA 02451 (US)
(72) Inventor: KENNEDY, Adam, Santa Barbara CA 93111-2528 (US); BLACK, Stephen H., Tennessee Ridge, Tennessee 37178 (US); BAUR, Stefan T., Goleta CA 93117-3090 (US)
(74) Representative: Carpmaels & Ransford LLP
(86) International application number: PCT/US2012/036557
(87) International publication number: WO 2012/154575

(56) References cited:
- WO-A1-2006/101270
- US-A1- 2005 029 432
- US-A1- 2005 161 587
- US-A1- 2008 048 120
- US-A1- 2008 308 928

## Description

### RELATED APPLICATIONS

WO2006101270 describes a plurality of sensor packages that are fixed to a circuit assembly board and placed on a lower mold die of a transfer molding apparatus. Attached inside a cavity of an upper mold die is a protection sheet, which will make contact with the upper face of a cover glass of each sensor package. When the upper mold die meshes with the lower mold die, the upper face of the cover glass is tightly covered with the protection sheet. A plunger is activated to fill the cavities with sealing resin. The upper face of the cover glass is not stained or damaged when the peripheries of the sensor packages are sealed.

US2008308928A1 describes provides an image sensor module with a three-dimensional die-stacking structure. By filling a conductive material into through silicon vias within at least one image sensor die, and into via holes within an insulating layer, vertical electrical connections are formed between the image sensor die and an image processor buried in the insulating layer. A plurality of solder bumps is formed on a backside of the image sensor module so that the module can be directly assembled onto a circuit board.

US2008048120 describes an infrared image detector system mounted on a printed circuit board (PCB) which is disclosed for use with an infrared imaging system such as an infrared camera. A semiconductor die having an infrared detector array and connection points on a first surface is mounted to a PCB and electrically coupled to electrical connection points on a PCB. In addition, a heat sink can be coupled to an opposing second surface of the semiconductor die. Still further, the PCB can have a window within which the infrared image detector array can be positioned so that the infrared image detector system can be mounted to one side of the PCB while infrared radiation incident on the second side of the PCB will reach the infrared image detector array through the window.

### BACKGROUND

Imaging systems may include electronics that facilitate generating an image based on detected electromagnetic radiation (e.g., light). In certain situations, certain functional components of an imaging system's electronics may be fabricated on a die comprising semiconductor material. The die may be sealed in a package comprising pin connectors. The packaged die may be incorporated into a printed wiring board that interconnects the pins connectors with other functional components (e.g., other packaged dies) using wire bonding or soldering. Unfortunately, the use of printed wiring boards comprising packaged dies tends to increase the size, weight, and cost of the imaging system.

### SUMMARY OF THE DISCLOSURE

According to the present invention there is provided a method of manufacturing a multi-chip system in a package (MCSiP) as claimed in claim 1 hereinafter and a product manufactured using the method.

According to some embodiments, a camera includes a multi-chip system in a package (MCSiP). The MCSiP comprising a set of electronics, an encapsulate, and a plurality of interconnects. The set of electronics includes a plurality of bare integrated circuit dies and other passive or active electronic components. Each die is operable to provide a functional component of a computing system operable to receive a signal describing electromagnetic radiation detected by an imaging sensor and facilitate generating an image according to the signal. The encapsulate comprises an adhesive molding compound deposited outwardly from the set of electronics in order to hold the set of electronics in position. The interconnects communicatively couple each die to other dies, the other electronic components, or components external to the MCSiP.

In certain embodiments, the set of electronics comprises monolithic electronics comprising a plurality of bare integrated circuit dies and other passive and active components, with many of the components embedded in an adhesive molding compound (e.g., encapsulate) used to generate the MCSiP. Accordingly, elements of a multichip module (MCM) and a system in a package (SiP) may be used to form the camera. Electrical interconnection between the components may be accomplished by successive layers of deposited dielectric and patterned metal, with the connection between layers and the underlying components being achieved using a plurality of vias.

In one embodiment, the imaging chip (e.g., a chip including a microbolometer or other imager) is directly bonded to the monolithic electronics (e.g., the MCSiP), with the electrical interconnection between the imaging chip and the monolithic electronics being furnished through wire bonds. Protection of the fragile wire bonds is achieved through an adhesive over mold/encapsulation.

Alternatively, a protective cover may be employed to serve the function of protecting the wire bonds. In certain alternate embodiments, the imaging chip may be physically separated from the monolithic electronics, and an electrical interconnection between the imaging chip and the monolithic electronics may be furnished through a flex cable or PWB.

In an embodiment containing a thermal detector, such as a microbolometer, thermal management may be provided by a heat spreader, which serves to diffuse any localized heating in the monolithic electronics associated with the MCSiP. The heat
spreader may be embedded into the monolithic electronics or placed as a discrete component under the imaging chip.

Certain embodiments of the invention may provide one or more technical advantages. A technical advantage of one embodiment may be that certain imaging system components may be provided using a multi-chip system in a package (MCSiP). Using MCSiP may reduce the footprint of the camera's computing system and may allow for short path lengths between various camera components, such as the sensor, the processor, and the memory. Reducing the path length may reduce the need for noise suppression features associated with longer path lengths, such as those found on standard printed wiring board configurations. By reducing the need for components used for noise suppression (e.g., discrete capacitors), the cost and the size of the camera may be further reduced.

Certain embodiments of the invention may include none, some, or all of the above technical advantages. One or more other technical advantages may be readily apparent to one skilled in the art from the figures, descriptions, and claims included herein.

### BRIEF DESCRIPTION OF THE DRAWINGS

For a more complete understanding of the present invention and its features and advantages, reference is now made to the following description, taken in conjunction with the accompanying drawings, in which:
FIGURE 1 illustrates an example of an imaging system including a camera that may be used to generate an image of a scene;
FIGURE 2 illustrates an example of a multi-chip system in a package that may include a computing system for the camera described in FIGURE 1; and
FIGURE 3 illustrates an example method of manufacture for the multi-chip system in a package described in FIGURE 2.

### DETAILED DESCRIPTION OF THE DRAWINGS

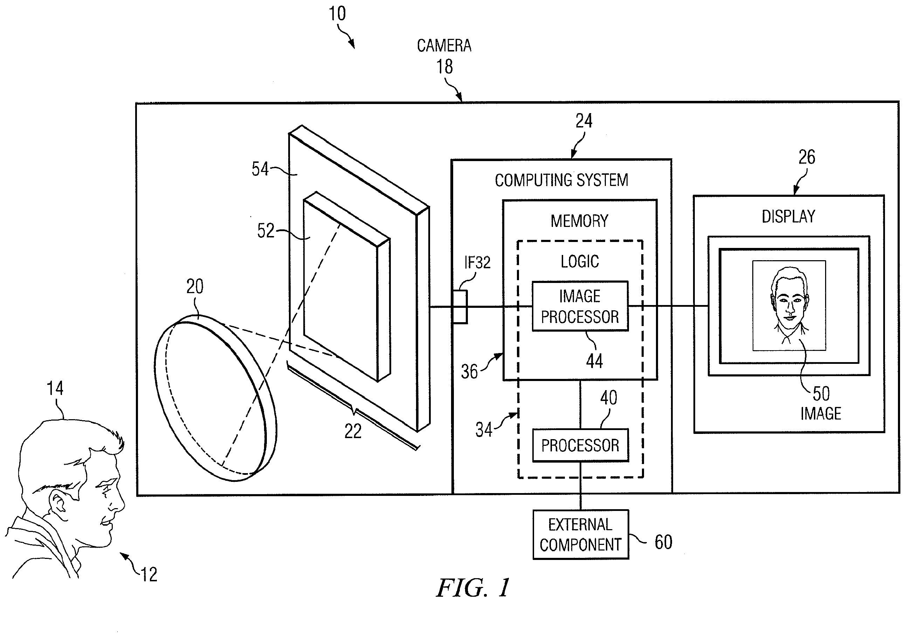

Embodiments of the present invention and its advantages are best understood by referring to FIGURES 1 through 3 of the drawings, like numerals being used for like and corresponding parts of the various drawings.

Imaging systems may include electronics that facilitate generating an image based on detected electromagnetic radiation (e.g., light). In certain situations, certain functional components of an imaging system's electronics may be fabricated on a die comprising semiconductor material. The die may be sealed in a package comprising pin connectors. The packaged die may be incorporated into a printed wiring board that interconnects the pins connectors with other functional components (e.g., other packaged dies) using wire bonding or soldering. Unfortunately, the use of printed wiring boards comprising packaged dies tends to increase the size, weight, and cost of the imaging system.

Certain embodiments of the disclosure may utilize multi-chip system in a package (MCSiP) in an imaging system. MCSiP may refer to a high density packaging technology first developed for the cell phone industry. In certain embodiments, utilizing MCSiP in an imaging system involves building a wafer up by selecting and positioning a plurality of dies (e.g., integrated circuit dies) and discrete components, if any, and then applying an epoxy encapsulate. The resulting wafer is then run through a conventional silicon back end process. For example, the back end process may deposit successive layers of dielectric and metal to facilitate interconnecting the dies and/or the discrete components. Additional levels of integration may be achieved by bonding multiple MCSiP layers and interconnecting them, for example, using wafer vias. Examples of advantages associated with MCSiP include, but are not limited to, the elimination of chip packages (cost and volume savings), elimination of a complex printed wiring board (cost savings), shorter design cycle times compared to an application-specific integrated circuit (ASIC) (weeks rather than many months), and the ability to rapidly integrate conventionally incompatible process technologies, such as high voltage analog, bipolar, deep submicron complementary metal-oxide semiconductor (CMOS), and gallium arsenide (GaAs) technologies.

FIGURE 1 illustrates an example of an imaging system 10 that may be used to generate an image 50 of a scene 12. In the illustrated example, scene 12 includes objects 14. System 10 includes camera 18 operable to interface with one or more external components 60, such as external device(s) and/or external network(s). As illustrated, camera 18 includes optics 20, detector 22, computing system 24, and display 26. Detector 22 includes a sensor 52 (e.g., an imaging sensor, such as a focal plane array) and an integrated circuit 54. Computing system 24 includes an interface 32, logic 34, and a memory 36. Logic 34 includes one or more processors 40 and applications such as an image processor 44. Memory 36 stores applications. Display 26 displays image 50 of scene 12. Camera 18 may optionally interface with an external component 60, such as an external display, a printer, a memory device, a computing device (e.g., an image post-processor), a network, and so on. A network may refer to any interconnecting system capable of transmitting audio, video, signals, data, messages, or any combination of the preceding. Examples include all or a portion of a public switched telephone network (PSTN), a public or private data network, a local area network (LAN), a metropolitan area network (MAN), a wide area network (WAN), a local, regional, or global communication or computer network such as the Internet, a wireline or wireless network (e.g., 802.11, time division multiple access (TDMA), code division multiple access (CDMA), and so on), an enterprise intranet, or any other suitable communication link, including combinations thereof.

In the illustrated example, scene 12 includes objects 14 that reflect and/or emit electromagnetic radiation that may be used to generate image 50 of scene 12. As an example, electromagnetic radiation reflected and/or emitted by objects 14 may include light, such as visible light, infrared light, ultraviolet light, or a combination of the preceding. Camera 18 receives electromagnetic radiation (light) from scene 12. Optics 20 refracts or reflects the light to direct the light towards sensor 52. Optics 20 may comprise one or more optical devices such as lenses. Sensor 52 may comprise an array (such as a two-dimensional array) of detector elements that can detect light and generate detector signals in response to the detected light. The detector signal corresponding to a detector element includes array data that represents the amount and/or wavelength of light that is detected by the detector element. Examples of focal plane arrays include complementary metal-oxide-semiconductor (CMOS) imagers, charge coupled devices, hybrid infrared imagers, microbolometers, and/or arrays of materials that are sensitive to the desired electromagnetic radiation from scene 12. Sensor 52 may be configured to detect any suitable spectrum of light, such as visible light and infrared light. For example, in certain embodiments sensor 52 may comprise a microbolometer operable to detect infrared wavelengths.

Integrated circuit 54 controls operation of and/or processes signals from sensor 52. In certain embodiments, integrated circuit 54 reads and outputs the detector signals. An example of integrated circuit 54 is a read-out integrated circuit (ROIC). Integrated circuit 54 may include several components that control operation of and/or processes signals from sensor 52. In certain embodiments, integrated circuit 54 includes power circuitry that controls power to sensor 52 and/or operates as a power converter, timing circuitry that provides clock signals, synchronization circuitry that synchronizes the timing of sensor 52, amplifying circuitry that amplifies signals from sensor 52, filter circuitry that filters signals from sensor 52, and/or an analog-to-digital (A/D) circuitry that digitizes video signals generated by sensor 52. In other embodiments, some or all of the preceding features may be performed by computing system 24. For example, computing system 24 may include power circuitry, timing circuitry, synchronization circuitry, amplifying circuitry, filter circuitry, and/or analog-to-digital (A/D) circuitry operable to provide control signals or other signals to integrated circuit 54 and/or to receive signals from integrated circuit 54.

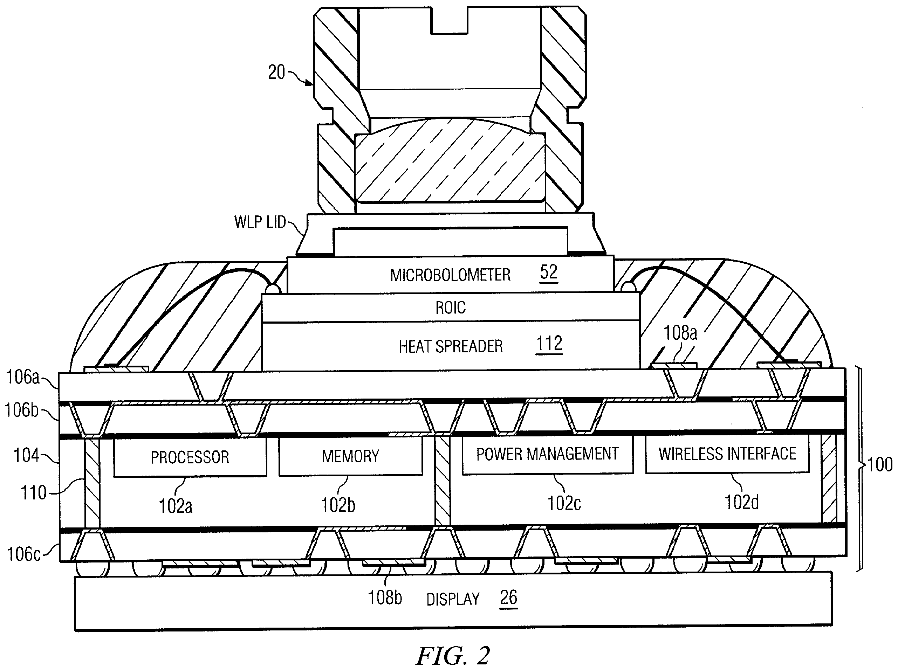

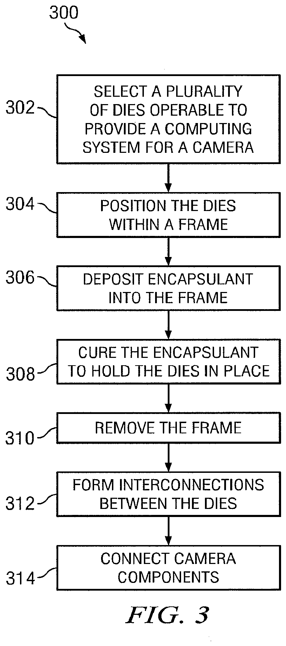

Computing system 24 facilitates the operation of and/or processes signals of system 10. In certain embodiments, image processor 44 processes array data provided by detector 22 to yield image data used to display image 50 on display 26. Image data for a pixel of image 50 may indicate the amount and/or wavelength of light detected by a detector element that corresponds to the pixel. A scan of substantially all detector elements of sensor 52 may yield a frame of data. A frame of focal plane data may be used to generate a frame of image data used to display image 50 at a particular time. Frames may be generated at successive times to yield a moving image 50 of scene 12. In certain embodiments, some or all of the components of computing system 24 may be included in a multi-chip system in a package (MCSiP) as described with respect to FIGURES 2 and 3 below. Computing system 24 may output the signals according to any suitable protocol, such as the national television system committee (NTSC) protocol, phase alternating line (PAL) protocol, or sequential color with memory (SECAM) protocol.

In certain embodiments, image processor 44 may perform other suitable operations. For example, image processor 44 may perform a sharpening operation on focal plane data to sharpen image 50. As another example, image processor 44 may perform an image recognition operation that detects certain features, such as colors or outlines.

Display 26 may be any suitable device configured to display image 50 of scene 12 using image data. Display 26 may be any suitable size and/or shape. In certain embodiments, camera 18 may house display 26 and/or camera 18 may interface with an external display (e.g., external component 60). In certain embodiments, display 26 is sufficiently small to be placed in close proximity (such as less than 1, 1 to 2, or 2 to 5 inches) to a human eye such that image 50 fits within the vision of the eye. Examples of such displays 50 include head mounted displays (HMDs) and displays for eyepieces of optical devices, such as binoculars, telescopes, or night vision goggles. Head mounted displays are devices that may be worn by a user and include a relatively small computer display that is positioned in front of the user's eyes.

FIGURE 2 illustrates an example of an MCSiP 100 that may be included in camera 18. In certain embodiments, MCSiP 100 includes a set of monolithic electronics comprising a plurality of bare integrated circuit dies and other passive & active components, with many of the components embedded in an adhesive molding compound (e.g., an encapsulate). MCSiP 100 may provide some or all of the functional components of camera 18's computing system 24. As described with respect to FIGURE 1, computing system 24 facilitates generating image 50 according to a signal that imaging sensor 52 provides in response to detecting electromagnetic radiation. Examples of electromagnetic radiation detected by sensor 52 include ultraviolet light, visible light, and/or infrared light. In certain embodiments, visible light sensors may comprise CMOS, CCD, SiPIN, or other visible sensing material.

In certain embodiments, MCSiP 100 comprises a plurality of dies 102. Each die 102 may provide a functional component of computing system 24. For example, a die may include processing elements (e.g., image recognition elements, data formatting elements, communications elements), discrete components (e.g., resistors, capacitors, inductors), memory, or other electronics. As an example, FIGURE 2 illustrates die 102a comprising processor 44 configured to provide image processing. Processor 44 receives the signal from sensor 52 and formats the signal to facilitate displaying or analyzing image 50.

As another example, FIGURE 2 illustrates die 102b comprising memory 36 operable to store operating parameters associated with camera 18. Examples of operating parameters include camera operating parameters and sensor operating parameters, such as non-uniformity correction (NUC) coefficients. Alternatively, some or all of the operating parameters may be stored in memory associated with processor 44 of die 102a and/or memory external to MCSiP 100.

In certain embodiments, MCSiP 100 may include any suitable number of dies 102 in order to implement the selected functionality. Examples of functionalities that may be provided by dies 102 include power circuits 102c (e.g., circuits operable to control power and/or convert power), timing circuits, synchronization circuits, amplifying circuits, filter circuits, and analog-to-digital (A/D) circuits (e.g., to convert an analog signal from sensor 52 into a digital format to facilitate processing or manipulating the signal).

In certain embodiments, one or more dies 102d may include an interface circuit operable to facilitate communication with external components 60. Examples of external components 60 include devices and/or networks external to camera 18. Certain interface circuits may facilitate communicating with a physical connector (e.g., a serial cable, a universal serial bus (USB) connector, and so on) or a wireless connector (e.g., an 802.11 chip) in order to provide information from sensor 52 to external components 60. In certain embodiments die 102d may comprise a wireless interface mounted to or integrated in MCSiP 100. Interface circuits may communicate the information for any suitable purpose, such as to display, store, post-process, or distribute image 50.

MCSiP 100 may include an encapsulate 104, such as an epoxy. In general, during manufacture each die 102 may be placed in a selected position relative to the other dies 102. The position may be selected to facilitate interconnecting dies 102 or for any other reason. Once in place, encapsulate 104 may be applied to dies 102. Encapsulate 104 may then be cured in order to hold dies 102 in place.

In certain embodiments, MCSiP 100 comprises one or more interconnect layers 106. Interconnect layers 106 include a plurality of interconnects 108 operable to interconnect a particular die 102 to other dies 102 and/or to components external to MCSiP 100. Interconnects 108 may be formed according to any suitable semiconductor technique, such as photolithography. Similarly, a particular interconnect layer 106 may be connected to other interconnect layers 106 through any suitable semiconductor technique, for example, through one or more vias 110.

In certain embodiments, MCSiP 100 integrates sensor 52. For example, MCSiP 100 and sensor 52 may be combined in a monolithic piece. In certain embodiments, sensor 52 may be mounted to MCSiP 100. As an example, detector 22 comprising sensor 52 may be a wafer level package mounted to MCSiP 100. Accordingly, interconnections between MCSiP 100 and integrated circuit 54 associated with sensor 52 may be relatively short and may facilitate space savings within camera 18. In certain embodiments, a heat spreader 112 may be positioned between MCSiP 100 and sensor 52 to prevent sensor 52 from creating noise or damaging electrical components of MCSiP 100. As an example, heat spreader 112 may comprise a metal plate having high thermal conductivity.

In certain embodiments, MCSiP 100 may be operable to interface with optics 20 (e.g., an optical element such as a lens). For example, MCSiP 100 may interface directly between optics 20 and sensor 52 to substantially reduce the alignment requirements thus making the part cheaper and easier to fabricate. Accordingly, the need for a focus adjustment may be reduced or eliminated. In other words, a direct interface between sensor 52 and an optical element of optics 20 may reduce some of the tolerance required on the part because additional elements that create a tolerance stack-up may be reduced or eliminated. In certain embodiments, the optical element could be integrated into the window or lid of the sensing element.

In certain embodiments, display 26 may be mounted/integrated into MCSiP 100. Display 26 may be positioned such that electromagnetic radiation comes in on one side of MCSiP 100 and the display is positioned on the opposite side of MCSiP 100.

In certain embodiments, MCSiP 100 described in FIGURE 2 may allow for manufacture of a complete and very small camera.

FIGURE 3 illustrates an example of a method 300 for manufacturing MCSiP 100 for use in camera 18. The method begins at step 302 by selecting a plurality of dies 102. Each die 102 is operable to provide a functional component of camera 18's computing system 24. Functional components of computing system 24 may facilitate receiving a signal from imaging sensor 52 and generating image 50 according to the signal. The signal describes electromagnetic radiation, such as ultraviolet light, visible light, and/or infrared light detected by sensor 52.

In certain embodiments, at least one of the selected dies 102a comprises an processor 44 operable to process images by receiving the signal and formatting the signal, for example, to facilitate displaying or analyzing image 50. In certain embodiments, at least one of the selected dies 102b comprises memory 36 operable to store operating parameters associated with camera 18, such as camera operating parameters and/or sensor operating parameters. Examples of other functional components that may be selected for MCSiP 100 include a power circuit, a timing circuit, a synchronization circuit, an amplifying circuit, a filter circuit, an analog-to-digital (A/D) circuit, and an interface circuit. In certain embodiments, a particular die 102 used in MCSiP 100 may be selected based on the fact that it has been proven to provide certain functionality. Accordingly, costs associated with developing a new die 102 may be reduced.

In certain embodiments, a particular die 102 may comprise different materials than the other dies 102. Thus, materials may be selected and optimized according to the functionality provided by the particular die 102. For example, materials selected for a capacitor may provide better capacitance, whereas materials selected for a resistor may provide better resistance. Examples of die materials include Group IV elemental semiconductors (e.g., elements having 4 electrons in the outer shell, such as silicon, germanium, tin, lead), Group IV compound semiconductors, III-V semiconductors (e.g., materials including a) a first element having three electrons in its outer shell, such as boron, aluminum, gallium, indium, and thallium, and b) a second element having five electrons in its outer shell, such as nitrogen, phosphorus, arsenic, antimony, and bismuth), II-VI semiconductors (e.g., materials including a) a first element having two electrons in its outer shell, such as zinc, cadmium, and mercury, and b) a second element having six electrons in its outer shell, such oxygen, sulfur, selenium, and tellurium). Although certain examples have been described, other semiconductors may be used (e.g., IV-VI semiconductors, V-VI semiconductors, and II-V semiconductors).

At step 304, the plurality of dies and any discrete components are positioned within a frame, and at step 306 an encapsulate, such as epoxy, is deposited into the frame. The encapsulate is cured at step 308 in order to hold the dies in position. When the encapsulate has been cured, the frame may be removed at step 310.

The method may proceed to step 312 to form interconnections 108 associated with dies 102. For example, MCSiP 100 may be configured with a plurality of interconnection layers 106. A particular interconnection layer 106 may be interconnected with the other interconnection layers 106 according to semiconductor techniques, such as through one or more vias 110. Interconnections 108 may be formed through the interconnection layers 106 in order to interconnect dies 102 with one another and/or with components external to MCSiP 100. Interconnections 108 may be formed according to semiconductor techniques, such as photolithography.

At step 314, MCSiP 100 may be directly or indirectly connected to other components of camera 18, such as optics 20, detector 22, and display 26. For example, in certain embodiments, detector 22 comprising sensor 52 may optionally be mounted to MCSiP 100. Heat spreader 112 may be positioned to dissipate heat from sensor 52 in order to prevent sensor 52 from creating noise or damaging electrical components of MCSiP 100. MCSiP 100 and the other components of camera 18 may be positioned in a camera housing. The method then ends.

Modifications, additions, or omissions may be made to the systems and apparatuses disclosed herein without departing from the scope of the invention. The components of the systems and apparatuses may be integrated or separated. Moreover, the operations of the systems and apparatuses may be performed by more, fewer, or other components. For example, the operations of integrated circuit 54 and computing system 24 may be performed by one component, or the operations of image processor 44 may be performed by more than one component. Additionally, operations of the systems and apparatuses may be performed using any suitable logic comprising software, hardware, and/or other logic. As used in this document, "each" refers to each member of a set or each member of a subset of a set.

Modifications, additions, or omissions may be made to the methods disclosed herein without departing from the scope of the invention. The methods may include more, fewer, or other steps. Additionally, steps may be performed in any suitable order.

A component of the systems and apparatuses disclosed herein may include an interface, logic, memory, and/or other suitable element. An interface receives input, sends output, processes the input and/or output, and/or performs other suitable operation. An interface may comprise hardware and/or software.

Logic performs the operations of the component, for example, executes instructions to generate output from input. Logic may include hardware, software, and/or other logic. Logic may be encoded in one or more tangible media and may perform operations when executed by a computer. Certain logic, such as a processor, may manage the operation of a component. Examples of a processor include one or more computers, one or more microprocessors, one or more field programmable gate arrays, one or more digital signal processors, one or more applications, and/or other logic.

In particular embodiments, the operations of the embodiments may be performed by one or more computer readable media encoded with a computer program, software, computer executable instructions, and/or instructions capable of being executed by a computer. In particular embodiments, the operations of the embodiments may be performed by one or more field programmable gate arrays configured by firmware to implement logical functions. In particular embodiments, the operations of the embodiments may be performed by one or more computer readable media storing, embodied with, and/or encoded with a computer program and/or having a stored and/or an encoded computer program.

A memory stores information. A memory may comprise one or more non-transitory, tangible, computer-readable, and/or computer-executable storage media. Examples of memory include computer memory (for example, Random Access Memory (RAM) or Read Only Memory (ROM)), mass storage media (for example, a hard disk), removable storage media (for example, a Compact Disk (CD) or a Digital Video Disk (DVD)), database and/or network storage (for example, a server), and/or other computer-readable medium.

Certain embodiments of the invention may provide one or more technical advantages. In certain embodiments, including some or all of the components of computing system 24 in MCSiP 100 may reduce the size of computing system 24. For example, using MCSiP 100 may eliminate conventional die packaging (e.g., sealing the die and providing wire interconnects). Thus, the space required to accommodate die packaging may be eliminated. As another example, MCSiP 100 may allow dies 102 to be connected through photolithography. Photolithography may allow for relatively dense and/or intricate connections to be made. For example, photolithography may interconnect components on different layers 106 or levels of MCSiP 100. Accordingly, photolithography may require less space than wire bonding, soldering, or other techniques used to interconnect packaged dies in a printed wiring board. In certain embodiments, MCSiP 100 including computing system 24 of camera 18 may be less than 1.5 in², less than 1 in², less than 0.75 in², or less than 0.5 in².

Certain embodiments of the invention may include none, some, or all of the above technical advantages. One or more other technical advantages may be readily apparent to one skilled in the art from the figures, descriptions, and claims included herein.

Although this disclosure has been described in terms of certain embodiments, alterations and permutations of the embodiments will be apparent to those skilled in the art. Accordingly, the above description of the embodiments does not constrain this disclosure. Other changes, substitutions, and alterations are possible without departing from the scope of this disclosure, as defined by the following claims.

## Claims

1. A method for manufacturing a multi-chip system in a package (MCSiP) comprising a plurality of layers for a camera, the method **characterized by**:
positioning (304) a plurality of dies within a frame in a position that facilitates interconnecting the dies, each die operable to provide a functional component of a computing system of the camera, the computing system operable to receive a signal describing electromagnetic radiation detected by an imaging sensor and facilitate generating an image according to the signal;
depositing (306) an encapsulant outwardly from the dies;
curing (308) the encapsulant in order to hold the dies in their positions; and
removing (310) the frame, further comprising interconnecting (312) the dies according to a photolithographic technique.

2. The method of Claim 1 comprising mounting the image sensor to the MCSiP.

3. The method of Claim 1 further comprising positioning a heat spreader (112) between the imaging sensor (52) and the MCSiP.

4. The method of Claim 1, wherein at least one of the dies (102a) comprises a processor (44) for image processing, the processor (44) operable to receive the signal from the imaging sensor (52) and format the signal to facilitate displaying or analyzing the image.

5. The method of Claim 1, wherein at least one of the dies (102b) comprises a memory (36) operable to store operating parameters associated with the camera.

6. The method of Claim 1, the MCSiP (100) further comprising a circuit selected from the group consisting of a power circuit (102c), a timing circuit, a synchronization circuit, an amplifying circuit, a filter circuit, an analog-to-digital (A/D) circuit, and an interface circuit.

7. The method of Claim 1, the imaging sensor (52) operable to detect one or more of ultraviolet light, visible light, and infrared light.

8. The method of Claim 1, further comprising:
configuring the MCSiP with a plurality of interconnection layers;
connecting (312) the interconnection layers with one or more vias;
forming interconnections through the interconnection layers according to a photolithography technique in order to interconnect the plurality of dies.

9. The method of Claim 1, wherein interconnecting the dies involves using a plurality of vias.

## Patentansprüche

1. Verfahren zur Herstellung eines Multichip-Systems in einem Paket (MCSiP) umfassend mehrere Lagen für eine Kamera, wobei das Verfahren **gekennzeichnet ist durch**:
Positionieren (304) mehrerer Dies in einem Rahmen in einer Position, die die Verbindung der Dies ermöglicht, wobei jedes Die betrieben werden kann, um eine funktionelle Komponente eines Computersystems der Kamera bereitzustellen, wobei das Computersystem betrieben werden kann, um ein Signal zu empfangen, das elektromagnetische Strahlung beschreibt, die von einem Bildsensor erfasst wird, und die Erzeugung eines Bildes gemäß dem Signal zu ermöglichen;
Aufbringen (306) eines Verkapselungsmittels von den Dies nach außen;
Aushärten (308) des Verkapselungsmittels, um die Dies in ihren Positionen zu halten; und
Entfernen (310) des Rahmens,
ferner umfassend das Verbinden (312) der Dies gemäß einer photolithographischen Technik.

2. Verfahren nach Anspruch 1 umfassend das Montieren des Bildsensors am MCSiP.

3. Verfahren nach Anspruch 1, ferner umfassend das Positionieren eines Wärmeverteilers (112) zwischen dem Bildsensor (52) und dem MCSiP.

4. Verfahren nach Anspruch 1, wobei mindestens eines der Dies (102a) einen Prozessor (44) zur Bildverarbeitung umfasst, wobei der Prozessor (44) betrieben werden kann, um das Signal von dem Bildsensor (52) zu empfangen und das Signal zu formatieren, um die Anzeige oder Analyse des Bildes zu ermöglichen.

5. Verfahren nach Anspruch 1, wobei mindestens eines der Dies (102b) einen Speicher (36) umfasst, der zum Speichern von mit der Kamera verbundenen Betriebsparametern betrieben werden kann.

6. Verfahren nach Anspruch 1, wobei das MCSiP (100) ferner eine Schaltung umfasst, die aus der Gruppe bestehend aus einer Leistungsschaltung (102c), einer Zeitgeberschaltung, einer Synchronisationsschaltung, einer Verstärkerschaltung, einer Filterschaltung, einer Analog-Digital-Schaltung (A/D) und einer Schnittstellenschaltung ausgewählt wird.

7. Verfahren nach Anspruch 1, wobei der Bildsensor (52) betrieben werden kann, um ein ultraviolette Licht und/oder ein sichtbares Licht und/oder ein Infrarotlicht zu erfassen.

8. Verfahren nach Anspruch 1, ferner umfassend:
Auslegen des MCSiP mit mehreren Verbindungslagen; und
Verbinden (312) der Verbindungslagen mit einer oder mehreren Durchkontaktierungen;
Bilden von Verbindungen durch die Verbindungslagen gemäß einer photolithographischen Technik, um die mehreren Dies miteinander zu verbinden.

9. Verfahren nach Anspruch 1, wobei das Verbinden der Dies unter Verwendung mehrerer Durchkontaktierungen erfolgt.

## Revendications

1. Procédé de fabrication d'un système multipuce dans un boîtier (MCSiP) comprenant une pluralité de couches pour une caméra, le procédé étant **caractérisé par** :
le positionnement (304) d'une pluralité de dés à l'intérieur d'une trame dans une position qui facilite l'interconnexion des dés, chaque dé étant utilisable pour fournir une composante fonctionnelle d'un système informatique de la caméra, le système informatique étant utilisable pour recevoir un signal décrivant un rayonnement électromagnétique détecté par un capteur d'imagerie et faciliter la génération d'une image conformément au signal ;
le dépôt (306) d'un encapsulant vers l'extérieur à partir des dés ;
le durcissement (308) de l'encapsulant afin de maintenir les dés dans leurs positions ; et
l'élimination (310) de la trame,
le procédé comprenant en outre l'interconnexion (312) des dés selon une technique photolithographique.

2. Procédé selon la revendication 1, comprenant le montage du capteur d'image sur le MCSiP.

3. Procédé selon la revendication 1, comprenant en outre le positionnement d'un dissipateur thermique (112) entre le capteur d'imagerie (52) et le MCSiP.

4. Procédé selon la revendication 1, au moins l'un des dés (102a) comprenant un processeur (44) pour le traitement d'image, le processeur (44) étant utilisable pour recevoir le signal provenant du capteur d'imagerie (52) et formater le signal pour faciliter l'affichage ou l'analyse de l'image.

5. Procédé selon la revendication 1, au moins l'un des dés (102b) comprenant une mémoire (36) utilisable pour stocker des paramètres de fonctionnement associés à la caméra.

6. Procédé selon la revendication 1, le MCSiP (100) comprenant en outre un circuit choisi dans le groupe constitué par un circuit de puissance (102c), un circuit de temporisation, un circuit de synchronisation, un circuit d'amplification, un circuit de filtrage, un circuit analogique-numérique (A/N), et un circuit d'interface.

7. Procédé selon la revendication 1, le capteur d'imagerie (52) étant utilisable pour détecter une ou plusieurs parmi la lumière ultraviolette, la lumière visible et la lumière infrarouge.

8. Procédé selon la revendication 1, comprenant en outre :
la configuration du MCSiP avec une pluralité de couches d'interconnexion ;
la connexion (312) des couches d'interconnexion avec un ou plusieurs trous d'interconnexion ;
la formation d'interconnexions à travers les couches d'interconnexion selon une technique de photolithographie afin d'interconnecter la pluralité de dés.

9. Procédé selon la revendication 1, l'interconnexion des dés impliquant l'utilisation d'une pluralité de trous d'interconnexion.
